(19) **Europäisches Patentamt**
**European Patent Office**
**Office européen des brevets**

(11) Veröffentlichungsnummer : **0 308 623 B1**

(12) # EUROPÄISCHE PATENTSCHRIFT

(45) Veröffentlichungstag der Patentschrift :
**17.07.91 Patentblatt 91/29**

(51) Int. Cl.⁵ : **H03K 3/037, H03K 3/356**

(21) Anmeldenummer : **88112265.9**

(22) Anmeldetag : **28.07.88**

(54) **Synchronisier-Flipflop-Schaltungsanordnung.**

(30) Priorität : **17.09.87 DE 3731294**

(43) Veröffentlichungstag der Anmeldung :
**29.03.89 Patentblatt 89/13**

(45) Bekanntmachung des Hinweises auf die
Patenterteilung :
**17.07.91 Patentblatt 91/29**

(84) Benannte Vertragsstaaten :
**AT DE FR GB IT NL**

(56) Entgegenhaltungen :
**DE-A- 2 237 579**
**US-A- 3 795 829**
**US-A- 4 390 987**

(73) Patentinhaber : **Siemens Aktiengesellschaft**
**Wittelsbacherplatz 2**
**W-8000 München 2 (DE)**

(72) Erfinder : **Pribyl, Wolfgang, Dipl.-Ing.**
**Spitzwegstrasse 63 b**
**W-8012 Ottobrunn (DE)**

**Beschreibung**

Die Erfindung betrifft eine Synchronisier-Flipflop-Schaltungsanordnung nach dem Oberbegriff des Patentanspruches 1.

Synchronisier-Flipflop-Schaltungsanordnungen werden verwendet zum Synchronisieren von asynchronen Daten an Eingängen von elektrischen Schaltsystemen, insbesondere auch an Eingängen von integrierten Schaltkreisen. Dabei wird ein (zu einem beliebigen, unbestimmten Zeitpunkt auftretendes) Eingangssignal mit Auftreten eines (systeminternen) Taktsignales in das Schaltsystem übernommen. Aufgrund der in der Elektrotechnik üblichen endlichen Anstiegs- und Verzögerungszeiten elektrischer Signale treten sogenannte metastabile, d.h. undefinierte Zustände am Systemeingang auf, wenn das in das System zu übernehmende Eingangssignal einen Flankenwechsel aufweist in einem Zeitraum vor der wirksamen Flanke des die Übernahme auslösenden Taktsignales, der geringer ist als ein entsprechend definierter Mindestzeitraum. Dieses Problem ist ausführlich beschrieben in Mead/Convey : Introduction to VLSI-Systems, 3. Auflage, 1980, Seiten 236 bis 242.

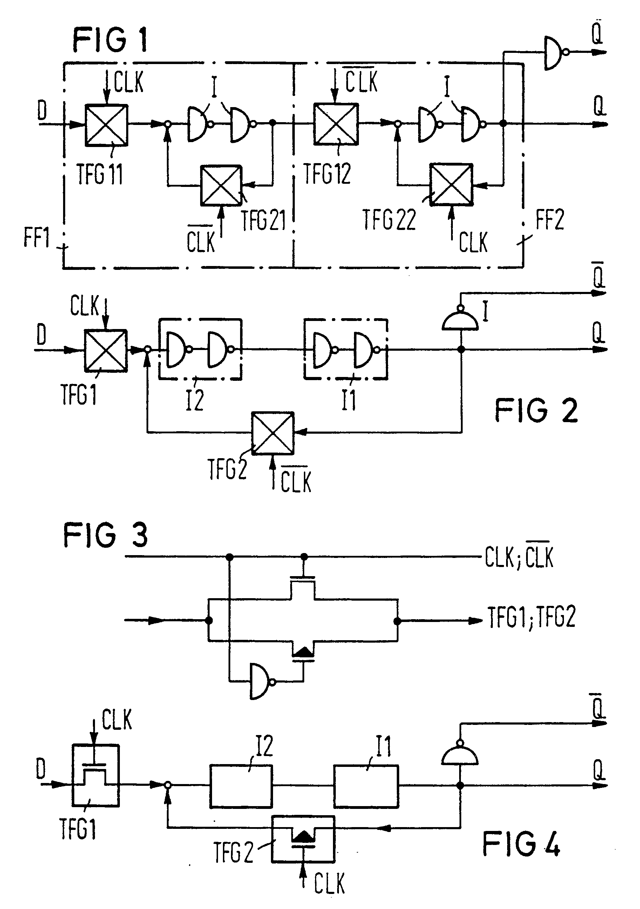

Übliche Synchronisier-Flipflop-Schaltungsanordnungen zur Minimierung des obengenannten Mindestzeitraumes, wie sie in ähnlicher Form aus DE-A-2 237 579 bekannt sind, sehen beispielsweise vor, komplette Flipflop-Stufen, die beispielsweise mehrere Inverter und Transfergates enthalten, mehrfach zu kaskadieren. Eine 2-fach-Kaskade als Beispiel ist in FIG 1 dargestellt : Eine erste Flipflop-Anordnung FF1 enthält zwei Inverter I, ein Transfergate TFG11 zur Übernahme eines Eingangssignales am Eingang D sowie ein weiteres Transfergate TFG21 zur Rückkopplung. Eine zweite Flipflop-Anordnung FF2, die inhaltlich aufgebaut ist wie die erste Flipflop-Anordnung FF1, ist dieser kaskadenartig nachgeschaltet. Sie wird durch Taktsignale $\overline{CLK}$, CLK gesteuert, die komplementär sind zu entsprechenden Taktsignalen CLK, $\overline{CLK}$ der ersten Flipflop-Anordnung FF1.

Nachteil dieses Prinzips der Kaskadierung ist eine dabei auftretende Phasenverzögerung im Werte von einer halben Taktperiode je der ersten Flipflop-Anordnung FF1 nachgeschalteten Kaskadenstufe (FF2 etc.).

Aufgabe der vorliegenden Erfindung ist es, eine gattungsgemäße Schaltungsanordnung anzugeben, die es erlaubt, den obengenannten Mindestzeitraum zu minimieren, ohne daß dabei die erwähnte Phasenverzögerung auftritt.

Diese Aufgabe wird gelöst durch die kennzeichnenden Merkmale des Patentanspruches 1.

Vorteilhafte Aus- und Weiterbildungen sind in Unteransprüchen gekennzeichnet.

Die Erfindung wird im folgenden anhand der FIG näher erläutert. Es zeigen :

FIG 1 eine Synchronisier-Flipflop-Schaltungsanordnung nach dem Stande der Technik, wie bereits beschrieben,

die FIG 2 bis 4 vorteilhafte Ausführungsformen der Erfindung.

Die erfindungsgemäße Synchronisier-Flipflop-Schaltungsanordnung nach FIG 2 enthält ein erstes Transfergate TFG1. Dieses ist am Eingang D der Synchronisier-Flipflop-Schaltungsanordnung angeordnet. Es ist über ein erstes Taktsignal CLK gesteuert. Die Steuerung kann dabei so ausgelegt sein, daß ein am Eingang D anliegendes Eingangssignal beispielsweise im High-Zustand des ersten Taktsignales CLK übernommen wird. Eine Übernahme im Low-Zustand ist als Alternative ebenfalls vorstellbar ; ein Schaltungsentwickler kann hier frei wählen.

Zwischen dem ersten Transfergate TFG1 und dem Ausgang Q der Synchronisier-Flipflop-Schaltungsanordnung sind erfindungsgemäß eine erste (I1) und eine zweite Inverteranordnung I2 vorgesehen. Während die erste Inverteranordnung I1 auch bei einer Flipflop-Anordnung nach dem Stande der Technik vorhanden ist (s. FIG 1), ist die zweite Inverteranordnung I2 demgegenüber neu. Dies führt einerseits zu einer guten Verstärkung mit steilen Flanken des Eingangssignales und andererseits zu einer deutlichen Erhöhung der Bandbreite am Eingang der Synchronisier-Flipflop-Schaltungsanordnung, wodurch der zuvor erwähnte Mindestzeitraum, innerhalb dessen metastabile Zustände auftreten können, wesentlich verkürzt wird. Dies bedeutet, daß sich die Wahrscheinlichkeit für das Auftreten der metastabilen Zustände ebenfalls wesentlich verringert.

Zwischen dem ersten Transfergate TFG1 und dem Ausgang Q der Schaltungsanordnung ist, parallel zu den beiden Inverteranordnungen I1, I2, ein zweites Transfergate TFG2 angeordnet, über das das am Ausgang Q der Schaltungsanordnung anstehende Ausgangssignal auf die Inverteranordnungen I1, I2 zurückgekoppelt ist. Das zweite Transfergate TFG2 ist über ein zweites Taktsignal $\overline{CLK}$ gesteuert, das gegenüber dem ersten Taktsignal CLK invertiert ist.

Der Betrieb der Synchronisier-Flipflop-Schaltungsanordnung ist einfach zu beschreiben : Mittels des ersten Taktsignales CLK wird bei durch das zweite Taktsignal $\overline{CLK}$ gesperrtem zweitem Transfergate TFG2 das am Eingang D anliegende Eingangssignal über das erste Transfergate TFG1 übernommen. Anschließend wird das Eingangssignal über die (mindestens) zwei Inverteranordnungen I1, I2 mehrfach invertiert und dabei verstärkt. In dieser Form liegt es zunächst am Ausgang Q an sowie über einen Inverter I an einem weiteren Ausgang $\overline{Q}$, der gegenüber dem einen Ausgang Q, wie bei Flipflops üblich, einen invertierten Signalverlauf aufweist.

Die Haltefunktion der Synchronisier-Flipflop-Schaltungsanordnung kommt durch die rückkoppelnde Wirkung des zweiten Transfergates TFG2 zustande : Während das erste Taktsignal CLK die Synchronisier-Flipflop-Schaltungsanordnung mittels des ersten Transfergates TFG1 vom Eingang D abkoppelt, wird mittels des zweiten Transfergates TFG2, gesteuert durch das zweite Taktsignal $\overline{CLK}$, das am Ausgang Q anliegende Ausgangssignal auf die Inverteranordnungen I1, I2 rückgekoppelt. Durch die vorteilhafte Kombination von wenigstens zwei Inverteranordnungen I1, I2 mit der das zweite Transfergate TFG2 enthaltenden Rückkopplungsschleife innerhalb einer einzigen Synchronisier-Flipflop-Schaltungsanordnung kommt die vorteilhafte Wirkung der Erfindung zustande : Verringerung der Gefahr des Auftretens metastabiler Zustände ohne Verlust von Taktzyklen.

Erweitert man die beschriebenen beiden Inverteranordnungen I1, I2 um weitere Inverteranordnungen, so läßt sich die Gefahr des Auftretens der metastabilen Zustände weiter verringern.

Ob die erfindungsgemäße neue Inverteranordnung I2 (bzw. weitere Inverteranordnungen) vor der bereits beim Stande der Technik vorhandenen Inverteranordnung I1 angeordnet ist, wie in FIG 2 gezeigt, oder nach dieser, ist vom Schaltungsprinzip her unwichtig. Es ist jedoch besonders vorteilhaft, die einzelnen Inverter der Inverteranordnungen I1, I2 in CMOS-Technologie zu gestalten. CMOS-Inverter weisen bekanntlich besonders steile Übertragungskennlinien auf, was die Möglichkeit des Auftretens der metastabilen Zustände weiter verringert.

Ebenfalls vorteilhaft ist es, die Transfergates TFG1, TFG2 zweikanalig mit Transistoren vom zueinander komplementären Typ (CMOS-Transistoren) auszuführen, wie in FIG 3 gezeigt : Dabei sind vorteilhafterweise zwei Transistoren parallelgeschaltet. Dies ermöglicht eine hohe Schaltgeschwindigkeit und eine große Pegelsicherheit. Es ist allerdings zu beachten, daß die Gates beider Transistoren mit zueinander komplementären Taktsignalen anzusteuern sind (CLK und $\overline{CLK}$ beim ersten Transfergate TFG1 ; $\overline{CLK}$ und CLK beim zweiten Transfergate TFG2).

Eine weitere vorteilhafte Ausführungsform zeigt FIG 4 : Das erste Transfergate TFG1 enthält einen n-Kanal-Transistor, der durch das erste Taktsignal CLK angesteuert wird. Das zweite Transfergate TFG2 enthält einen p-Kanal-Transistor, der ebenfalls durch das erste Taktsignal CLK angesteuert wird. Durch diese Anordnung entfällt zum einen das zweite Taktsignal $\overline{CLK}$ und zum anderen arbeiten die beiden Transfergates TFG1, TFG2 trotzdem im Gegentakt zueinander.

## Patentansprüche

1. Synchronisier-Flipflop-Schaltungsanordnung
   – mit einem ersten Transfergate (TFG1), das am Eingang (D) der Synchronisier-Flipflop-Schaltungsanordnung angeordnet ist und das über ein erstes Taktsignal (CLK) gesteuert ist,
   – mit einer ersten, aus zwei hintereinandergeschalteten Invertern (I) bestehenden Inverteranordnung (I1) zwischen dem ersten Transfergate (TFG1) und dem Ausgang (Q) der Synchronisier-Flipflop-Schaltungsanordnung und
   – mit einem zweiten Transfergate (TFG2), das ebenfalls zwischen dem ersten Transfergate (TFG1) und dem Ausgang (Q) der Synchronisier-Flipflop-Schaltungsanordnung angeordnet ist und das über ein gegenüber dem ersten Taktsignal (CLK) invertiertes zweites Taktsignal ($\overline{CLK}$) gesteuert ist, **dadurch gekennzeichnet, daß** zwischen dem ersten Transfergate (TFG1) und dem Ausgang (Q) der Synchronisier-Flipflop-Schaltungsanordnung in Serie zur ersten Inverteranordnung (I1) wenigstens eine zweite, gleichartige Inverteranordnung (I2) angeordnet ist.

2. Synchronisier-Flipflop-Schaltungsanordnung nach Anspruch 1, **dadurch gekennzeichnet, daß** die Inverteranordnungen (I1, I2) CMOS-Inverter enthalten.

3. Synchronisier-Flipflop-Schaltungsanordnung nach Anspruch 1 oder Anspruch 2, **dadurch gekennzeichnet, daß** wenigstens eines der Transfergates (TFG1 ; TFG2) 2-kanalig mit Transistoren vom zueinander komplementären Typ ausgeführt ist.

4. Synchronisier-Flipflop-Schaltungsanordnung nach einem der vorhergehenden Ansprüche, **dadurch gekennzeichnet, daß** das erste Transfergate (TFG1) n-Kanal-Transistoren enthält, daß das zweite Transfergate (TFG2) p-Kanal-Transistoren enthält und daß das zweite Transfergate (TFG2) anstelle einer Steuerung durch das zweite Taktsignal ($\overline{CLK}$) ebenfalls mit dem ersten Taktsignal (CLK) gesteuert wird.

## Claims

1. Synchronising flip-flop circuit arrangement
   – having a first transfer gate (TFG1) which is disposed at the input (D) of the synchronising flip-flop circuit arrangement and is controlled by a first clock signal (CLK),
   – having a first inverter arrangement (I1) composed of two series-connected inverters (I) between the first transfer gate (TFG1) and the output (Q) of the synchronising flip-flop circuit arrangement, and
   – having a second transfer gate (TFG2) which is likewise disposed between the first transfer gate (TFG1) and the output (Q) of the synchronising flip-flop circuit arrangement and is controlled by a second clock signal ($\overline{CLK}$) inverted with respect to the first clock signal (CLK), characterised in that at least one second identical inverter arrangement (I2) is disposed in series with the first inverter arrangement (I1) between the first transfer gate (TFG1) and the output (Q) of the synchronising flip-flop circuit arrangement.

2. Synchronising flip-flop circuit arrangement according to Claim 1, characterised in that the inverter arrangements (I1, I2) contain CMOS inverters.

3. Synchronising flip-flop circuit arrangement according to Claim 1 or Claim 2, characterised in that at least one of the transfer gates (TFG1 ; TFG2) is of two-channel design with transistors of a mutually complementary type.

4. Synchronising flip-flop circuit arrangement according to one of the preceding claims, characterised in that the first transfer gate (TFG1) contains n-channel transistors, in that the second transfer gate (TFG2) contains p-channel transistors, and in that the second transfer gate (TFG2) is likewise controlled by the first clock signal (CLK) instead of a control by the second clock signal $\overline{(CLK)}$.

**Revendications**

1. Montage à bascules bistables de synchronisation, comportant
    – une première porte de transfert (TSG1), disposée à l'entrée (D) du montage à bascules bistables de synchronisation et commandée par un premier signal de cadence (CLK),
    – un premier dispositif inverseur (I1) constitué par deux inverseurs (I) branchés en série et situé entre la première porte de transfert (TFG1) et la sortie (Q) du montage à bascules bistables de synchronisation, et
    – une seconde porte de transfert (TG2), également disposée entre la première porte de transfert (TFG1) et la sortie (Q) du montage à bascules bistables de synchronisation et commandée par un second signal de cadence $\overline{(CLK)}$ inversé par rapport au premier signal de cadence (CLK), caractérisé par le fait qu'entre la première porte de transfert (TFG1) et la sortie (Q) du montage à bascules bistables de synchronisation est prévu au moins un second dispositif inverseur identique (I2), en série avec le premier dispositif inverseur (I1).

2. Montage à bascules bistables de synchronisation suivant la revendication 1, caractérisé par le fait que les dispositifs inverseurs (I1, I2) comportent des inverseurs CMOS.

3. Montage à bascules bistables de synchronisation suivant la revendication 1 ou 2, caractérisé par le fait qu'au moins l'une des portes de transfert (TFG1 ; TFG2) est réalisée à 2 canaux avec des transistors de types complémentaires l'un à l'autre.

4. Montage à bascules bistables de synchronisation suivant l'une des revendications précédentes, caractérisé par le fait que la première porte de transfert (TFG1) comporte des transistors à canal n, que la seconde porte de transfert (TFG2) comporte des transistors à canal p et que la seconde porte de transfert (TFG2) est commandée, non pas par une commande au moyen du second signal de cadence $\overline{(CLK)}$, mais également par le premier signal de cadence (CLK).

## FIG 1

## FIG 2

## FIG 3

## FIG 4